# EUROPEAN PATENT APPLICATION

(11) **EP 2 445 002 A2**
(43) Date of publication of application: **25.04.2012**
(21) Application number: 11186118.3
(22) Date of filing: 21.10.2011
(51) Int. Cl.: H01L 21/67

(54) **Apparatus and method for surface treatment in a furnace**

(30) Priority: 21.10.2010 US 405418 P
(71) Applicant: Sandvik Thermal Process, Inc., Sonora, CA 95370 (US)
(72) Inventor: Reynolds, Reese, Los Gatos, CA California 95032 (US); Johnson, James T, Sonora, CA California 95370 (US); Helms, Aubrey Lynn Jr, Los Gatos, CA California 95032 (US); Lucas, H. William Jr, Watsonville, CA California 95076 (US)
(74) Representative: Melin Granberg, Linda

(57) **Abstract**

The present invention relates apparatus and methods for treating the surfaces of substrates in a furnace to enhance the subsequent deposition of thin films or to enhance the reaction of the surfaces with gas phase components. Exhaust systems and methods of their use allow the exhaust gases to be conveyed to proper gas treatments facilities. Door seal and inert gas purge systems allow the furnace to be operated safely and minimize the reaction of the process gases in the door seal region.

## Description

### FIELD OF INVENTION

This invention relates generally to the field of treating the surfaces of substrates in a furnace to enhance the subsequent deposition of thin films or to enhance the reaction of the surfaces with gas phase components.

### BACKGROUND OF THE INVENTION

Early integrated circuits used diffusion processes to incorporate dopant atoms into the silicon surface to change the electrical characteristics and the conductivity of the silicon. Common dopant atoms included phosphorous, boron, arsenic, and antimony, but others were used as well. This step in the integrated circuit manufacturing process is commonly known as the "diffusion" step. The diffusion behavior of common dopant atoms has been well characterized in both multi-crystalline and single crystal silicon substrates. Factors that influence the diffusion behavior of dopant atoms comprise dopant source concentration, silicon crystal structure (i.e. multi-crystalline or single crystal), crystal surface orientation for single crystal applications, the presence and concentration of pre-existing doping in the substrate surface, dopant exposure time, peak temperature and temperature history, time held at peak temperature, surface cleanliness, and the presence of a thin film at the substrate surface (i.e. native oxide or thin deposited layers). The resulting concentration of the dopant atom as a function of depth into the substrate surface after the diffusion process is well known in the art.

The advancement of integrated circuit technology and the subsequent requirements for high concentrations of dopant atoms constrained to shallow depths from the surface led to the diffusion step being replaced by an ion implantation process followed by a rapid thermal anneal (RTA) process used to activate the implanted dopant species. Therefore, diffusion processes have not been used in leading edge integrated circuits for many years.

Photovoltaic (PV) solar cells based on silicon technology have been known for many decades and have recently begun to be manufactured in high volume. Wafer based PV solar cells based on other material systems are also well know, but have not progressed to high volume manufacture. Recent trends such as high costs of conventional energy sources, lower materials costs, lower equipment costs, improved solar cell efficiency, and an increased adoption of renewable energy technologies has allowed the use of wafer based PV solar cells to become cost competitive with conventional energy sources in the generation of electricity. The concentration of the dopant atom as a function of depth into the substrate surface for wafer based PV solar cells is not as stringent as that of silicon based integrated circuits. Therefore, diffusion processes are often used to introduce dopant atoms into the wafer surface to change the electrical characteristics and the conductivity of the substrate.

The efficiency of the wafer based PV solar cells is sensitive to many factors. Some of these factors comprise the presence of contaminants in the bulk silicon, silicon crystal structure (i.e. multi-crystalline or single crystal), the presence and concentration of pre-existing doping in the substrate surface, dopant exposure time, peak temperature and temperature history, time held at peak temperature, surface cleanliness, the presence of a thin film at the substrate surface (i.e. native oxide or thin deposited layers), the concentration of carrier recombination centers on the surface, the concentration of carrier recombination centers within the bulk of substrate, and the PV solar cell architecture.

The profitability of the wafer based PV solar cell manufacturing process and the ultimate cost per watt of electricity produced (i.e. $/watt) is sensitive to the number and complexity of the various steps used to produce the wafer based PV solar cell. A balance and compromise must be made between optimized efficiency and the manufacturing cost to produce the solar cell. Trade-offs must be made between complicated and costly cleaning and pre-treatment steps before the diffusion step and the final manufacturing cost of the solar cell. For example, the success of the diffusion step may be enhanced by ensuring that the surfaces of the substrates are freshly cleaned and free of contaminants and native oxide layers. This can be accomplished by cleaning the substrates in a hydrofluoric acid (HF) solution (for silicon based PV solar cells) and then completing the diffusion process within a specified amount of time. This may impractical or too costly in a large PV solar cell factory where tens of millions of solar cells are manufactured each year. A great benefit would be realized if fast, cost effective processes could be developed to properly treat the surface of the substrates before or during the solar cell manufacturing process.

Therefore, a need exists in the art for the development of apparatus and methods that facilitate the pre-treatment, cleaning, conditioning, etc. of the surface of the substrates prior to many of the steps used in the manufacture of wafer based PV solar cells.

### SUMMARY OF THE INVENTION

Accordingly and advantageously the present invention provides apparatus and methods that allow the surface of the substrate to be pre-treated, cleaned, conditioned, etc. prior to a diffusion, annealing, or deposition step in the manufacturing process of a wafer based solar cell. The apparatus and methods also facilitate the inclusion of a pre-treatment, cleaning, conditioning, etc. step as an integral part of a multi-step process that might be accomplished within a single diffusion, annealing, or deposition apparatus.

In some embodiments of the present invention, an exhaust system is provided as part of a furnace system that allows the pressure within the tube to be reduced to facilitate the introduction of a gas used to pre-treat, clean, condition, etc. the surface of the substrates. The exhaust system comprises components that allow the pre-treatment, cleaning, conditioning, etc. exhaust flow to be diverted to a specific gas treatment system while the exhaust flow during the diffusion, annealing, or deposition process is diverted to a separate gas treatment system. The selection of the pathway of the exhaust flow is typically controlled by the control system of the furnace and may be selected for each step of a typical recipe.

In some embodiments of the present invention, a door closure system is provided as part of a furnace system that provides an active inert gas purge of the door region during a diffusion, annealing, deposition, pre-treatment, cleaning, conditioning, etc. step of a furnace process. The inert gas purge acts to prevent reactive gases from escaping the door seal of the furnace during the above mentioned processes. Additionally, the inert gas purge acts to prevent the possible deposition of material in the door seal region of the furnace or the corrosion of the door seal region of the furnace.
In some embodiments of the present invention, several examples of inert gas purge systems are provided.

In some embodiments of the present invention, a door closure system is provided as part of a furnace system that allows the pressure within the tube to be reduced to facilitate the introduction of a gas used to pre-treat, clean, condition, etc. the surface of the substrates. The door closure system typically provides a seal with a leak rate that falls within a range selected during the design of the furnace. The leak rate range is selected so that the leak rate range is less than between one-quarter and one-half of the exhaust flow imparted by the exhaust system. This provides a seal that prevents the pre-treatment, cleaning, conditioning, etc. gas from escaping the tube in the door region. Furthermore, this provides a seal that facilitates a flow of air from outside the tube, through the seal, and into the tube to act as a purge of the door seal area during the pre-treatment, cleaning, conditioning, etc. step. In some embodiments of the present invention, several examples of door closure systems are provided.

These and other advantages are achieved in accordance with the present invention as described in detail below.

### BRIEF DESCRIPTION OF THE DRAWINGS

To facilitate understanding, identical reference numerals have been used, where possible, to designate identical elements that are common to the figures. The drawings are not to scale and the relative dimensions of various elements in the drawings are depicted schematically and not to scale.

The techniques of the present invention can readily be understood by considering the following detailed description in conjunction with the accompanying drawings, in which:

FIG. 1 illustrates the configuration of one embodiment of an exhaust system.

FIGs. 2A and 2B illustrate the configurations of several embodiments of a door closure system incorporating inert gas purge capabilities.

FIGs. 3A and 3B illustrate the configurations of several embodiments of a door closure system incorporating a known leak rate range capability.

### DETAILED DESCRIPTION OF THE INVENTION

After considering the following description, those skilled in the art will clearly realize that the teachings of the invention can be readily utilized in the design and operation of apparatus used in diffusion, annealing, and deposition steps of the manufacture of wafer based solar cells.

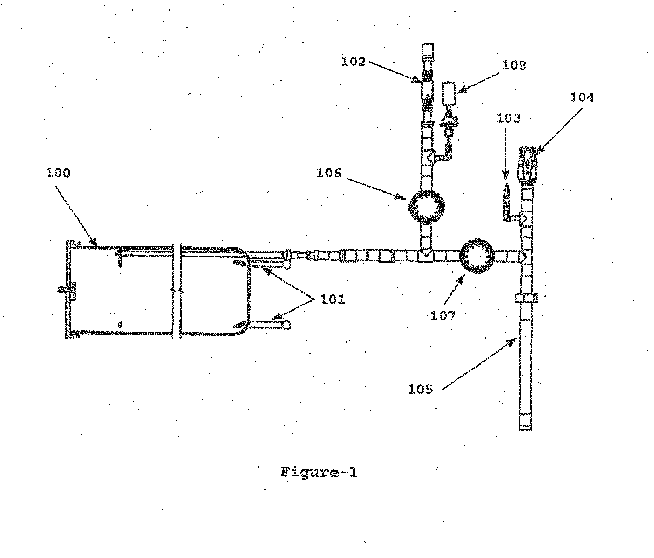

**FIG. 1** illustrates the configuration of one embodiment of an exhaust system. The rear end of the process tube, **100,** is shown. By convention, it is understood that the end of the process tube wherein the wafers are inserted is called the "front" of the process tube and the opposite end is called the "rear". Exhaust tubes, **101,** penetrate the rear of the process tube and convey exhaust gases from the exhaust manifolds (not shown) that are positioned within the process tube to the proper facilities to safely treat the exhaust gases. The design and function of the exhaust manifolds positioned within the process tube are described in patent application 12/711,838 also owned by the present Assignee which is hereby incorporated by reference in its entirety for all purposes.

During the diffusion, anneal, or deposition steps, the exhaust gases are conveyed along the exhaust tubing and exit through the process exhaust valve, **104.** During the diffusion, anneal, or deposition steps, valve **107** is open and valve **106** is closed. The exhaust line leading from process exhaust valve, **104,** leads to exhaust gas treatment facilities configured to safely treat the exhaust gases present during the diffusion, anneal, or deposition steps. Examples of suitable gas treatment facilities include high volume dilution, wet scrubbers, burn boxes, gas reaction columns, gas absorbers, and the like. Drain trap, **105,** is used to collect condensable by-products from the diffusion, anneal, or deposition process step. Pressure monitor, **103,** is used to monitor the pressure of the process tube during this step. For example, during the doping of silicon using phosphorous oxy-chloride (POCl₃) as a source of phosphorous, condensable by-products are typically trapped in a system such as drain trap, **105.**

During the pre-treatment, cleaning, conditioning, etc. step, process exhaust valve, **104,** is closed and valve **107** is closed. Valve, **106,** is opened and the exhaust gases are conveyed along the exhaust tubing and exit through the valve, **106.** The exhaust line leading from process exhaust valve, **106,** leads to a source of vacuum and then to exhaust gas treatment facilities configured to safely treat the exhaust gases present during the pre-treatment, cleaning, conditioning, etc. step. Examples of suitable vacuum include high flow process exhaust fans, venture pumps, mechanical vacuum pumps, and the like. Examples of suitable gas treatment facilities include high volume dilution, wet scrubbers, burn boxes, gas reaction columns, gas absorbers, and the like. Pressure monitor, **108,** is used to monitor the pressure in the exhaust line and the furnace tube. Typically, it is advantageous to reduce the pressure within the tube below one atmosphere during the pre-treatment, cleaning, conditioning, etc. step.

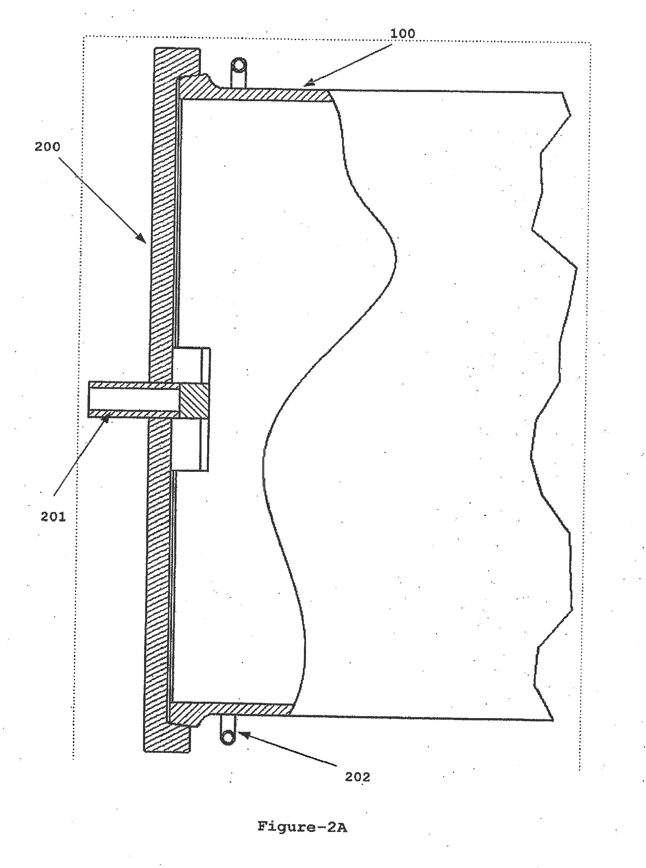

**FIG. 2A** illustrates one of the configurations of several embodiments of a door closure system incorporating inert gas purge capabilities. Door, **200,** forms a seal at the front of the process tube, **100.** The seal between door, **200,** and process tube, **100,** may be made by any number of methods. Typical sealing methods comprise adjacent flat surfaces, ground joints, high temperature elastomeric seals, and the like. **FIG. 2A** illustrates the use of a controlled leak input tube, **201,** that penetrates door, **200.** Controlled leak input tube, **201,** is used to introduce an active inert gas purge in the front region of the process tube during a diffusion, annealing, deposition, pre-treatment, cleaning, conditioning, etc. step of a furnace process. The inert gas purge acts to prevent reactive gases from escaping the door seal of the furnace during the above mentioned processes. Additionally, the inert gas purge acts to prevent the possible deposition of material in the door seal region of the furnace or the corrosion of the door seal region of the furnace. At the end of controlled leak input tube, **201,** that is inside the volume of the process tube, the gas may be dispersed through common techniques such as a diffuser, a showerhead, a distributed gas plenum, etc.

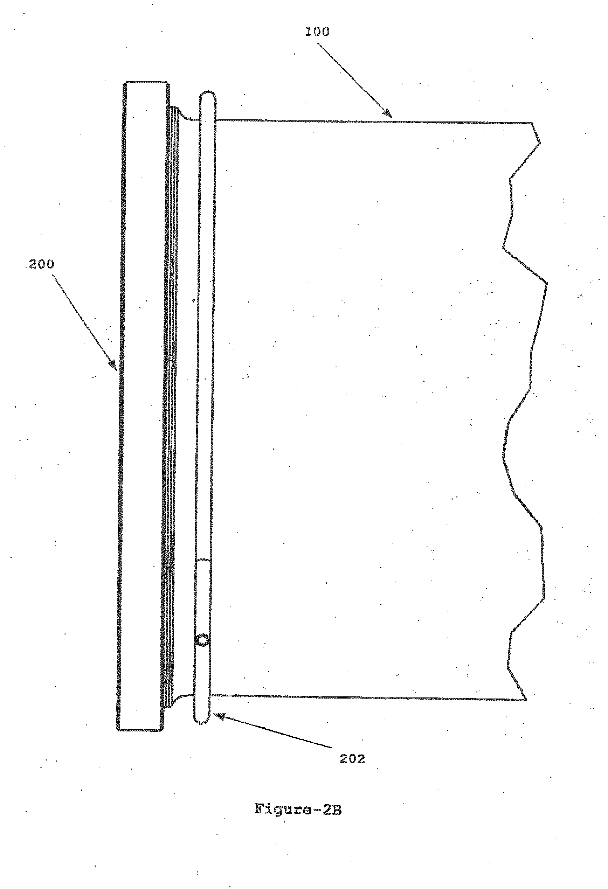

**FIG. 2B** illustrates one of the configurations of several embodiments of a door closure system incorporating inert gas purge capabilities. Door, **200**, forms a seal at the front of the process tube, **100.** The seal between door, **200**, and process tube, **100,** may be made by any number of methods. Typical sealing methods comprise adjacent flat surfaces, ground joints, high temperature elastomeric seals, and the like. **FIG. 2B** illustrates the use of a controlled leak annular ring, **202**, that penetrates process tube, **100**. Controlled leak annular ring, **202,** is used to introduce an active inert gas purge in the front region of the process tube during a diffusion, annealing, deposition, pre-treatment, cleaning, conditioning, etc. step of a furnace process. The inert gas purge acts to prevent reactive gases from escaping the door seal of the furnace during the above mentioned processes. Additionally, the inert gas purge acts to prevent the possible deposition of material in the door seal region of the furnace or the corrosion of the door seal region of the furnace. Controlled leak annular ring, **202**, will have one or more penetrations into the process tube. The inert gas may optionally be dispersed through common techniques such as a diffuser, a showerhead, a distributed gas plenum, etc. at each penetration from controlled leak annular ring, **202**, into process tube **100.** Typically, if a sufficient number of penetrations from controlled leak annular ring, 202, into process tube **100** are used, no additionally dispersion techniques are required.

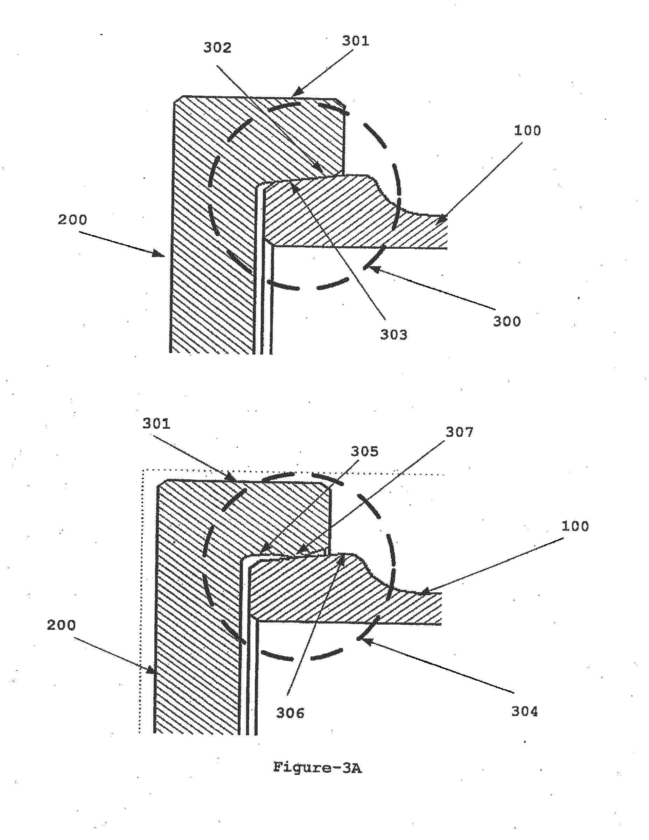

**FIG. 3A** illustrates two configurations of several embodiments of a door closure system incorporating a known leak rate range capability. Door, **200**, forms a taper seal with process tube, 100. Door, **200**, has a lip, 301, that forms a concave cavity into which the end of process tube, **100**, may be inserted. The interior surface of the door lip, **302**, and the exterior surface, **303**, of the end of process tube, **100**, are advantageously angled to improve the alignment, contact, and sealing integrity of the two surfaces. The angle of the two mating surfaces, **302** and **303**, is typically between 5 degrees and 45 degrees relative to the longitudinal axis of process tube, 100, and advantageously between 10 degrees and 20 degrees. An illustration of the details of one embodiment of the seal is shown within the circle denoted as **300** in **FIG. 3A**. In this configuration, the force used to engage the door, 200, with the end of the process tube, **100**, is distributed over the entire surface area of the two angled surfaces, **302** and **303**.

An alternate door closure system incorporating a known leak rate range capability is also illustrated in **FIG. 3A**. Door, **200**, forms a single line seal with process tube, **100**. Door, **200**, has a lip, **301**, that forms a concave cavity into which the end of process tube, **100**, may be inserted. The interior surface, **305**, of the lip of door, **200**, and the exterior surface, **306**, of the end of process tube, **100**, are advantageously angled to improve the alignment, contact, and sealing integrity of the two surfaces. The angle is typically between 5 degrees and 45 degrees relative to the longitudinal axis of process tube, **100**, and advantageously between 10 degrees and 20 degrees. An illustration of the details of one embodiment of the seal is shown within the circle denoted as **304** in **FIG. 3A**. In this embodiment, the angled surface, **305**, of door, **200**, additionally comprises a bump or bead, **307**, which forms a raised surface along the circumference of the sealing surface, **305**, of door, **200**. Bump or bead, **307**, will then form a tight seal with a small area when engaged with the angled sealing surface, **306**, on the end of tube, **100**. This seal configuration allows the force used to engage the door, **200**, with the end of the process tube, **100**, to be concentrated on the smaller sealing surface, thus resulting in a seal with a smaller leak rate.

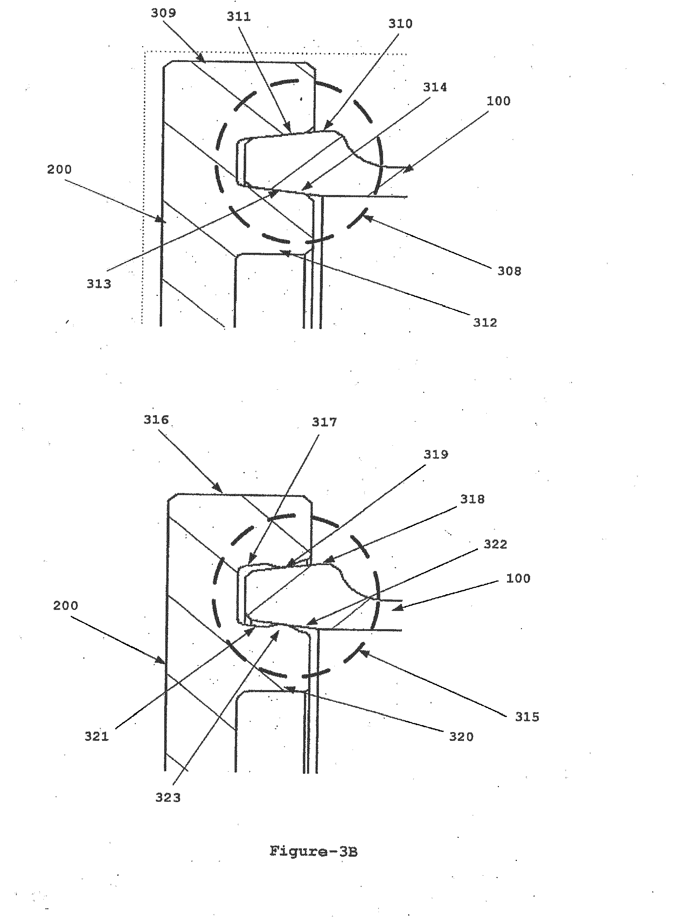

**FIG. 3B** illustrates two configurations of several embodiments of a door closure system incorporating a known leak rate range capability. Door, **200**, forms a double taper seal with process tube, **100**. Door, **200**, has an exterior lip, **309**, that forms a concave cavity into which the exterior surface, **310**, of the end of process tube, **100**, may be inserted. The interior surface of the door lip, **311**, and the exterior surface, **310**, of the end of process tube, **100**, are advantageously angled to improve the alignment, contact, and sealing integrity of the two surfaces. The angle of the two mating surfaces, **310** and **311**, is typically between 5 degrees and 45 degrees relative to the longitudinal axis of process tube, **100**, and advantageously between 10 degrees and 20 degrees. Door, **200**, additionally comprises an inner flange, **312**, that comprises an exterior sealing surface, **313**, that engages with the interior surface, **314**, of the end of process tube, **100**. The exterior surface of the door lip, **313**, and the interior surface, **314**, of the end of process tube, **100**, are advantageously angled to improve the alignment, contact, and sealing integrity of the two surfaces. The angle of the two mating surfaces, 313 and **314**, is typically between negative 5 degrees and 45 degrees relative to the longitudinal axis of process tube, **100**, and advantageously between negative 10 degrees and 20 degrees. An illustration of the details of one embodiment of the seal is shown within the circle denoted as **308** in **FIG. 3A**. In this configuration, the force used to engage the door, **200**, with the end of the process tube, **100**, is distributed over the entire surface area of the angled surfaces, **310**, **311**, **313**, and **314**.

An alternate door closure system incorporating a known leak rate range capability is also illustrated in **FIG. 3A**. Door, **200**, forms a double line seal with process tube, **100**. Door, **200**, has a lip, 316, that forms a concave cavity into which the end of process tube, **100**, may be inserted. The interior surface, **317**, of the lip of door, **200**, and the exterior surface, **318**, of the end of process tube, **100**, are advantageously angled to improve the alignment, contact, and sealing integrity of the two surfaces. The angle is typically between 5 degrees and 45 degrees relative to the longitudinal axis of process tube, **100**, and advantageously between 10 degrees and 20 degrees. An illustration of the details of one embodiment of the seal is shown within the circle denoted as **315** in **FIG. 3A**. In this embodiment, the angled surface, **317**, of door, **200**, additionally comprises a bump or bead, **319**, which forms a raised surface along the circumference of the sealing surface, **317**, of door, **200**. Bump or bead, **319**, will then form a tight seal with a small area when engaged with the angled sealing surface, 318, on the end of tube, **100**. Door, **200**, additionally comprises an inner flange, **320**, that comprises an exterior sealing surface, **321**, that engages with the interior surface, **322**, of the end of process tube, **100**. The exterior surface of the door lip, **321**, and the interior surface, **322**, of the end of process tube, **100**, are advantageously angled to improve the alignment, contact, and sealing integrity of the two surfaces. The angle of the two mating surfaces, **321** and **322**, is typically between negative 5 degrees and 45 degrees relative to the longitudinal axis of process tube, **100,** and advantageously between negative 10 degrees and 20 degrees. In this embodiment, the angled surface, **321,** of door, **200,** additionally comprises a bump or bead, **323,** which forms a raised surface along the circumference of the sealing surface, **321,** of door, **200.** Bump or bead, **323,** will then form a tight seal with a small area when engaged with the angled sealing surface, **322,** on the end of tube, **100.** This seal configuration allows the force used to engage the door, **200,** with the end of the process tube, **100,** to be concentrated on the smaller sealing surfaces, thus resulting in a seal with a smaller leak rate.

In some embodiments of the present invention, methods of implementing the exhaust system disclosed above are used to facilitate the use different process steps with different pressure and gas treatment requirements in a furnace. Typically, diffusion and annealing steps in furnaces for the manufacture of wafer based solar cells are executed at about atmospheric pressure. Simple exhaust systems are used to convey the exhaust gases to appropriate gas treatment systems. Typically, deposition steps in furnaces for the manufacture of wafer based solar cells are executed at reduced pressures. Simple vacuum systems are used to convey the exhaust gases to appropriate gas treatment systems. If a different step in the diffusion, annealing or deposition process such as a pre-treatment, cleaning, conditioning, etc. step requires a different pressure or an alternate gas treatment technology, some embodiments of the present invention allow the exhaust gases to be re-directed to an alternate exhaust path with additional equipment for controlling the process pressure and appropriate gas treatment technologies. Using **FIG. 1** as an exemplary exhaust system, during the diffusion, annealing, or deposition step, valve, **104,** is open to allow the exhaust gases to flow to gas treatment facilities appropriate for the gas chemistries being employed. Valve **107** is open to allow condensable materials to be collected in the drain trap, **105.** Pressure monitor, **103,** is used to monitor the pressure of the process tube during this step. Valve **106** is closed to prevent the exhaust gases from flowing through the secondary exhaust line. During a separate process step that requires a different pressure or an alternate gas treatment technology, valve, **107,** is closed to prevent the exhaust gases from interacting with the condensed material in the drain trap. Pressure monitor, **108,** is used to monitor the pressure of the process tube during this step. Valve **106** is opened and leads to a source of vacuum and then to exhaust gas treatment facilities configured to safely treat the exhaust gases present. Listed below are two generic methods for the use of some embodiments of the exhaust systems discussed above. For brevity, non-unique steps have not been listed. Those skilled in the art will appreciate that other commonly used steps comprising loading, stabilization, purging, temperature ramping, unloading and the like will be used to develop a full manufacturing process recipe. These methods are typically implemented as part of the control system for the furnace. Additionally, two specific examples will be given to illustrate the use of some embodiments of the exhaust systems discussed above. **FIG. 1** has been used to illustrate the valve sequence.

### Method-1 - surface pre-treatment, cleaning, conditioning, etc. before the diffusion, annealing, or deposition step

a) Load and prepare the furnace thermal conditions using typical steps
b) Close valve **107** and open valve **106** to direct the exhaust gas flow to the proper pressure control equipment and gas treatment equipment for the pre-treatment, cleaning, conditioning, etc. step
c) Using typical techniques, establish desired pressure and gas flows using inert gases
d) Switch gas flows to substitute the desired reactive gases for the inert gas using typical gas delivery techniques
e) Execute the pre-treatment, cleaning, conditioning, etc. step for the desired recipe time
f) Switch gas flows to substitute inert gas for the reactive gases for the using typical gas delivery techniques
g) Prepare the furnace thermal condition for the diffusion, annealing, or diffusion step
h) Close valve **106**, and open valves **107** and **104** to direct the exhaust gas flow to the proper pressure control equipment and gas treatment equipment for the diffusion, annealing, or diffusion step
i) Switch gas flows to substitute the desired reactive gases for the inert gas using typical gas delivery techniques
j) Execute the diffusion, annealing, or diffusion step for the desired recipe time
k) Switch gas flows to substitute inert gas for the reactive gases for the using typical gas delivery techniques
l) Prepare the furnace thermal conditions and unload the furnace using typical steps

### Method-2 - surface pre-treatment, cleaning, conditioning, etc. during multiple diffusion, annealing, or deposition steps

a) Load and prepare the furnace thermal conditions using typical steps
b) Close valve **106**, and open valves **107** and **104** to direct the exhaust gas flow to the proper pressure control equipment and gas treatment equipment for the diffusion, annealing, or diffusion step
c) Using typical techniques, establish desired pressure and gas flows using inert gases
d) Switch gas flows to substitute the desired reactive gases for the inert gas using typical gas delivery techniques
e) Execute the first diffusion, annealing, or diffusion step for the desired recipe time
f) Switch gas flows to substitute inert gas for the reactive gases for the using typical gas delivery techniques
g) Prepare the furnace thermal condition for the pre-treatment, cleaning, conditioning, etc. step
h) Close valve **107** and open valve **106** to direct the exhaust gas flow to the proper pressure control equipment and gas treatment equipment for the pre-treatment, cleaning, conditioning, etc. step
i) Using typical techniques, establish desired pressure and gas flows using inert gases
j) Switch gas flows to substitute the desired reactive gases for the inert gas using typical gas delivery techniques
k) Execute the pre-treatment, cleaning, conditioning, etc. step for the desired recipe time
l) Switch gas flows to substitute inert gas for the reactive gases for the using typical gas delivery techniques
m) Prepare the furnace thermal condition for the diffusion, annealing, or diffusion step
n) Close valve **106**, and open valves **107** and **104** to direct the exhaust gas flow to the proper pressure control equipment and gas treatment equipment for the diffusion, annealing, or diffusion step
o) Switch gas flows to substitute the desired reactive gases for the inert gas using typical gas delivery techniques
p) Execute the second diffusion, annealing, or diffusion step for the desired recipe time
q) Switch gas flows to substitute inert gas for the reactive gases for the using typical gas delivery techniques
r) Prepare the furnace thermal conditions and unload the furnace using typical steps

**Example 1 - Pre-diffusion pre-treatment, cleaning, conditioning, etc.**

In this example, "Method-1" as described above and the apparatus illustrated in **FIG. 1** will be used to illustrate the cleaning of the wafer surface before the diffusion step in the manufacture of wafer based solar cells. This example is for illustrative purposes only and does not serve to limit the scope of the present invention. Those skilled in the art will appreciate that the present invention may be applied to other wafer types, different pre-treatment, cleaning, conditioning, etc. chemistries, and different diffusion chemistries and still fall within the scope of the present invention.

Silicon based wafers are commonly used as substrates for wafer based solar cells. The silicon wafers may be multi-crystalline or single crystal. Typically, there is a diffusion step that is used to dope the wafer with phosphorous atoms during the solar cell manufacturing process. POCl₃ is commonly used as the source of the phosphorous atoms. This process is typically executed at about atmospheric pressure. Before the POCl₃ diffusion process, the wafers are typically cleaned in wet chemical equipment that is well known in the industry. However, it is not uncommon for the wafers to arrive at the POCl₃ diffusion step with a thin native oxide (SiOₓ) layer on the surface that grows due to the exposure to air. The POCl₃ diffusion process and ultimate solar cell efficiency may be enhanced if the diffusion step can be executed in a silicon surface that is free of contaminants and native oxide layers. One method to realize this goal is to implement an apparatus and method that allows the surface of the silicon wafer to be pre-treated, cleaned, conditioned, etc. before the POCl₃ diffusion step.

Typically, the silicon wafers are removed from cassettes and placed into quartz boats. The quartz boats are then loaded into the furnace at about 600 degrees Celsius. The furnace is purged with an inert gas such as N₂ to remove any air that may have been introduced during the loading process. The temperature is then ramped to the desired temperature for the pre-treatment, cleaning, conditioning, etc. step. In this example, a cleaning step will be described. Valve **107** is closed and valve **106** is opened to direct the exhaust flow to the proper pressure control equipment and gas treatment equipment. The cleaning step is typically executed at reduced pressure and is facilitated by directing the exhaust flow to a vacuum pump as is well known in the art. The vacuum pump serves to reduce the pressure in the process tube to the desired level. The effluent of the vacuum pump is directed to an appropriate gas treatment technology for the cleaning gas employed. Once the flow, pressure, and temperature of the furnace are established for the cleaning step, the inert gas flow is stopped and the reactive gas is introduced to begin the cleaning process. NF₃ is a good candidate as a cleaning gas because it will thermally decompose at 600 degrees Celsius and provide reactive fluorine atoms. The fluorine atoms are effective at removing the native oxide layer. The NF₃ is typically diluted in a suitable inert. Other examples of cleaning gases comprise HF, CF₄, F₂, Cl₂, CIF₃, etc. Door closure systems as illustrated in **FIGs 2A**, **2B**, **3A**, and **3B** are used to prevent the reactive gas from escaping the process tube at the door seal and from attacking the door seal region. The cleaning step is allowed to proceed for the desired length of time.

At the end of the cleaning step, the reactive gas flow is stopped and an inert gas purge is initiated to remove the reactive gas from the process tube. During this step, the temperature is ramped to the diffusion, annealing, or deposition step temperature. In this example, a diffusion step will be described. Once the target temperature is reached and stabilized, valve **106** is closed and valves **107** and **104** are opened to direct the exhaust flow to the proper pressure control equipment and gas treatment equipment for the diffusion step. Typically, the pressure is increased to about atmospheric pressure for a diffusion step. The inert gas flow is stopped and the reactive gas is introduced to begin the diffusion process. POCl₃ is a good candidate as a diffusion gas because it will thermally decompose and provide reactive phosphorous atoms. Other reactive gases such as O₂ are also typically used with the POCl₃ to facilitate the diffusion process. Other examples of diffusion gases comprise PH₂, BBr₃, B₂H₆, AsH₃, etc. Door closure systems as illustrated in **FIGs 2A**, **2B**, **3A**, and **3B** are used to prevent the reactive gas from escaping the process tube at the door seal and from attacking the door seal region. The diffusion step is allowed to proceed for the desired length of time.

At the end of the diffusion step, the reactive gas flow is stopped and an inert gas purge is initiated to remove the reactive gas from the process tube. During this step, the temperature is ramped to the unload temperature. When the unload temperature is reached, the quartz boats are removed from the furnace and allowed to cool. After cooling, the wafers are removed from the quartz boats and loaded into cassettes for transport to the next manufacturing process step.

**Example 2 - Pre-treatment, cleaning, conditioning, etc. step as an intermediate step in the process recipe**

In this example, "Method-2" as described above and the apparatus illustrated in **FIG. 1** will be used to illustrate the cleaning of the wafer surface before the diffusion step in the manufacture of wafer based solar cells. This example is for illustrative purposes only and does not serve to limit the scope of the present invention. Those skilled in the art will appreciate that the present invention may be applied to other wafer types, different pre-treatment, cleaning, conditioning, etc. chemistries, and different diffusion chemistries and still fall within the scope of the present invention.

Silicon based wafers are commonly used as substrates for wafer based solar cells. The silicon wafers may be multi-crystalline or single crystal. Typically, there is a diffusion step that is used to dope the wafer with phosphorous atoms during the solar cell manufacturing process. POCl₃ is commonly used as the source of the phosphorous atoms. This process is typically executed at about atmospheric pressure. The POCl₃ diffusion process may be used multiple times to dope the surface of the wafers with varying concentrations of phosphorous atoms. The exposure of the wafer surface to POCl₃ and O₂ results in the formation of an SiO₂ layer that is doped with phosphorous atoms. This layer must be removed before the next step in the manufacturing process. If a second diffusion step is desired, the wafer must be removed from the furnace before the second diffusion step is executed. This increases the time and cost for the manufacture of the solar cell. One method to realize this goal is to implement an apparatus and method that allows the surface of the silicon wafer to be pre-treated, cleaned, conditioned, etc. between the two POCl₃ diffusion steps.

Typically, the silicon wafers are removed from cassettes and placed into quartz boats. The quartz boats are then loaded into the furnace at about 600 degrees Celsius. The furnace is purged with an inert gas such as N₂ to remove any air that may have been introduced during the loading process. The temperature is then ramped to the desired temperature for the first diffusion, annealing, or deposition step. In this example, a diffusion step will be described. During this step, the temperature is ramped to the first diffusion step temperature. During this step, valves **107** and **104** are open and valve **106** is closed to direct the exhaust flow to the proper pressure control equipment and gas treatment equipment for the first diffusion step. Typically, the pressure is about atmospheric pressure for a diffusion step. The inert gas flow is stopped and the reactive gas is introduced to begin the diffusion process. POCl₃ is a good candidate as a diffusion gas because it will thermally decompose and provide reactive phosphorous atoms. Other reactive gases such as O₂ are also typically used with the POCl₃ to facilitate the diffusion process. Other examples of diffusion gases comprise PH₂, BBr₃, B₂H₆, AsH₃, etc. Door closure systems as illustrated in **FIGs 2A**, **2B**, **3A**, and **3B** are used to prevent the reactive gas from escaping the process tube at the door seal and from attacking the door seal region. The first diffusion step is allowed to proceed for the desired length of time.

At the end of the first diffusion step, the reactive gas flow is stopped and an inert gas purge is initiated to remove the reactive gas from the process tube. During this step, the temperature is ramped to the pre-treatment, cleaning, conditioning, etc. step. The temperature is then ramped to the desired temperature for the pre-treatment, cleaning, conditioning, etc. step. In this example, a cleaning step will be described. Valve **107** is closed and valve **106** is opened to direct the exhaust flow to the proper pressure control equipment and gas treatment equipment. The cleaning step is typically executed at reduced pressure and is facilitated by directing the exhaust flow to a vacuum pump as is well known in the art. The vacuum pump serves to reduce the pressure in the process tube to the desired level. The effluent of the vacuum pump is directed to an appropriate gas treatment technology for the cleaning gas employed. Once the flow, pressure, and temperature of the furnace are established for the cleaning step, the inert gas flow is stopped and the reactive gas is introduced to begin the cleaning process. NF₃ is a good candidate as a cleaning gas because it will thermally decompose and provide reactive fluorine atoms. The fluorine atoms are effective at removing the native oxide layer. The NF₃ is typically diluted in a suitable inert. Other examples of cleaning gases comprise HF, CF₄, F₂, Cl₂, CIF₃, etc. Door closure systems as illustrated in **FIGs 2A****,** **2B****,** **3A****,** and **3B** are used to prevent the reactive gas from escaping the process tube at the door seal and from attacking the door seal region. The cleaning step is allowed to proceed for the desired length of time.

At the end of the cleaning step, the reactive gas flow is stopped and an inert gas purge is initiated to remove the reactive gas from the process tube. During this step, the temperature is ramped to the second diffusion, annealing, or deposition step temperature. In this example, a second diffusion step will be described. Once the target temperature is reached and stabilized, valve **106** is closed and valves **107** and **104** are opened to direct the exhaust flow to the proper pressure control equipment and gas treatment equipment for the second diffusion step. Typically, the pressure is increased to about atmospheric pressure for the second diffusion step. The inert gas flow is stopped and the reactive gas is introduced to begin the second diffusion process. POCl₃ is a good candidate as a diffusion gas because it will thermally decompose and provide reactive phosphorous atoms. Other reactive gases such as O₂ are also typically used with the POCl₃ to facilitate the diffusion process. Other examples of diffusion gases comprise PH₂, BBr₃, B₂H₆, AsH₃, etc. Door closure systems as illustrated in **FIGs 2A****,** **2B****,** **3A****,** and **3B** are used to prevent the reactive gas from escaping the process tube at the door seal and from attacking the door seal region. The second diffusion step is allowed to proceed for the desired length of time.

At the end of the second diffusion step, the reactive gas flow is stopped and an inert gas purge is initiated to remove the reactive gas from the process tube. During this step, the temperature is ramped to the unload temperature. When the unload temperature is reached, the quartz boats are removed from the furnace and allowed to cool. After cooling, the wafers are removed from the quartz boats and loaded into cassettes for transport to the next manufacturing process step.

In the examples discussed above, cleaning and diffusion steps were described. Those skilled in the art will understand that the cleaning step may be substituted with other known pre-treatment or conditioning steps and still fall within the scope of the present invention. Likewise, those skilled in the art will understand that the diffusion step may be substituted with other known annealing or deposition steps and still fall within the scope of the present invention.

Although various embodiments which incorporate the teachings of the present invention have been shown and described in detail herein, those skilled in the art can readily devise many other varied embodiments that still incorporate these teachings.

## Claims

1. A door closure system, comprising:
a process tube including an end adapted for insertion of a wafer, the process tube including,
an exterior surface, and
a first mating surface disposed on the exterior surface at the end adapted for insertion of the wafer; and
a door adapted to mate with the end of the process tube, the door including,
a lip that forms a concave cavity into which the end of the process tube is inserted, and
a second mating surface that mates with the first mating surface of the process tube at an angle relative to a longitudinal axis of the process tube and is disposed on an interior surface of the lip.

2. A door closure system according to claim 1, further comprising a controlled leak input tube disposed on the door and extending through the door.

3. A door closure system according to claims 1 or 2, further comprising a controlled leak annular ring disposed on the exterior surface of the process tube, the controlled leak annular ring including one or more penetrations into the process tube.

4. A door closure system according to any of the preceding claims, further comprising a bump disposed on the interior surface of the lip and the second mating surface is disposed on the bump.

5. A door closure system according to any of the preceding claims , wherein the angle relative to the longitudinal axis of the process tube is between 5 degrees and 45 degrees, preferably between 10 degrees and 20 degrees.

6. A door closure system according to any of the preceding claims, wherein a force to engage the door with the end of the process tube is distributed over the first and second mating surfaces.

7. A door closure system according to any of the preceding claims, further comprising a flange disposed on the door adjacent to the lip and spaced apart from the lip.

8. A door closure system according to claim 7,
wherein the process tube further comprises,
an interior surface, and
a third mating surface disposed on the interior surface at the end adapted for insertion of the wafer, and
wherein the flange further comprises,
a surface that engages with the interior surface of the process tube, and
a fourth mating surface that mates with the third mating surface of the process tube at a second angle relative to the longitudinal axis of the process tube and is disposed on the surface of the flange that engages with the interior surface.

9. A door closure system according to claim 8, further comprising a second bump disposed on the surface of the flange that engages with the interior surface of the process tube and the fourth mating surface is disposed on the second bump.

10. A door closure system according to claim 8 or 9, wherein the second angle relative to the longitudinal axis of the process tube is between 5 degrees and 45 degrees, preferably between 10 degrees and 20 degrees.

11. A door closure system according to any one of claims 8, 9 and 10, wherein a force to engage the door with the end of the process tube is distributed over the first, second, third, and fourth mating surfaces.

12. An exhaust system, comprising:
a process tube including,
a first end,
a second end,
an exterior surface between the first end and the second end, and
a first mating surface disposed on the exterior surface at the first end;
a door adapted to mate with the first end of the process tube, the door including,
a lip that forms a concave cavity into which the first end of the process tube is inserted, and
a second mating surface that mates with the first mating surface of the process tube at an angle relative to a longitudinal axis of the process tube and is disposed on an interior surface of the lip; and
an exhaust tube penetrating the second end of the process tube.

13. An exhaust system according to claim 12, further comprising a controlled leak input tube disposed on the door and extending through the door.

14. An exhaust system according to claim 12 or 13, further comprising a controlled leak annular ring disposed on the exterior surface near the first end of the process tube, the controlled leak annular ring including one or more penetrations into the process tube.

15. An exhaust system according to any one of claims 12 to 14, further comprising a bump disposed on the interior surface of the lip and the second mating surface is disposed on the bump.

16. An exhaust system according to any one of claims 12 to 15, wherein the angle relative to the longitudinal axis of the process tube is between 5 degrees and 45 degrees, preferably between 10 degrees and 20 degrees.

17. An exhaust system according to any one of claims 12 to 16,
wherein the process tube further comprises,
an interior surface between the first end and the second end, and
a third mating surface disposed on the interior surface at the first end, and wherein the door further comprises,
a flange disposed on the door adjacent to the lip and spaced apart from the lip,
a surface on the flange that engages with the interior surface of the process tube at the first end, and
a fourth mating surface that mates with the third mating surface of the process tube at a second angle relative to the longitudinal axis of the process tube and is disposed on the surface of the flange that engages with the interior surface at the first end.
